(19) Europäisches Patentamt
European Patent Office
Office européen des brevets

(11) **EP 2 656 096 B1**

(12) **EUROPÄISCHE PATENTSCHRIFT**

(45) Veröffentlichungstag und Bekanntmachung des Hinweises auf die Patenterteilung:
**26.02.2020   Patentblatt 2020/09**

(51) Int Cl.:
*G01S 5/02* *(2010.01)*          *G01C 21/12* *(2006.01)*
*G01C 21/20* *(2006.01)*

(21) Anmeldenummer: **11793346.5**

(22) Anmeldetag: **04.11.2011**

(86) Internationale Anmeldenummer:
**PCT/EP2011/069401**

(87) Internationale Veröffentlichungsnummer:
**WO 2012/084322 (28.06.2012 Gazette 2012/26)**

(54) **POSITIONSBESTIMMUNG**

DETERMINATION OF POSITIONS

DÉTERMINATION DE POSITION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.12.2010   DE 102010063702**

(43) Veröffentlichungstag der Anmeldung:
**30.10.2013   Patentblatt 2013/44**

(73) Patentinhaber: **Robert Bosch GmbH**
**70442 Stuttgart (DE)**

(72) Erfinder:
• **EICKMANN, Jonas**
**52062 Aachen (DE)**
• **LAMMEL, Gerhard**
**72070 Tuebingen (DE)**

(56) Entgegenhaltungen:
EP-A1- 0 687 892          WO-A1-93/05587
JP-A- 4 364 491          US-A1- 2007 010 940
US-A1- 2009 085 806      US-B1- 6 502 033

**Beschreibung**

Die Erfindung betrifft ein Verfahren zur Positionsbestimmung, mit einem ersten Schritt, wobei aus Funksignalen im wesentlichen ortsfester Sender, eine erste Folge von Positionen bestimmt wird, wobei aus sonstigen Sensordaten durch Koppeln eine zweite Folge von Positionen bestimmt wird. Die Erfindung betrifft weiterhin ein Computerprogrammprodukt zur Durchführung des Verfahrens. Die Erfindung betrifft auch eine Positionsbestimmungseinrichtung.

Stand der Technik

Im kommerziellen Einsatz sind bisher hauptsächlich WLAN Ortungssysteme befindlich, die auf der Basis von Aussendungen identifizierbarer Sender (z.B. WLAN Router), sowie der gemessenen Empfangsstärke dieser Aussendungen an einem Empfänger, beispielsweise in einem Ortungsgerät dessen Position bestimmen. Hierzu gibt es prinzipiell zwei verschiedene Ansätze, die ais "Position Fingerprinting" bzw. "Signal Path Modelling" bezeichnet werden.

Beim "Position Fingerprinting" wird vor der Verwendung des Ortungssystems der gesamte Bereich, in dem das System verwendet werden soll, vermessen und auf einem Raster zu jeder Position die Empfangsstärken aller verfügbaren WLAN Netzwerke eingetragen. Im Betrieb des Ortungssystems werden die am Ortungsgerät gemessenen Empfangsstärken mit den in der Datenbank hinterlegten Empfangsstärken verglichen und über spezielle Algorithmen die Position berechnet. Der einfachste, denkbare Algorithmus gibt als Position diejenige Position aus der Datenbank an, deren gemessene Empfangsstärken den geringsten geometrischen Abstand zu den beim Orten gemessenen Empfangsstärken haben.

Beim "Signal Path Modelling" wird eine Datenbank mit den Positionen aller im Ortungsbereich befindlichen WLAN Basisstationen vorausgesetzt, die unter anderem durch Vermessung der Empfangsstärken im Ortungsbereich, wie in der Schrift US 7,403,762 beschrieben, bestimmt werden kann. Während der Ortung werden die am Endgerät gemessenen Empfangsstärken über einen mathematischen Zusammenhang in Abstände zur zugehörigen Basisstation umgerechnet und durch Trilateration auf Basis der bekannten Routerpositionen die aktuelle Position bestimmt. Die Trilateration unterscheidet sich hierbei von der bekannten Triangulation dadurch, dass nur Abstands- und keine Winkelinformationen verwendet werden.

Die Genauigkeit beider Methoden ist von der Qualität der zu Grunde liegenden Datenbank abhängig, da die Ortung niemals präziser als die durch die Datenbank gegebene Referenz sein kann. Die Störungen, die bei der Erstellung der Datenbank auftreten können sind hierbei vielfältig, da die gemessene Empfangsstärke nicht nur vom Abstand, sondern unter anderem auch von Objekten im Übertragungspfad, der Orientierung des Endgerätes und der Zeit abhängig ist. Zudem besteht die Möglichkeit, dass auch nach der Erstellung der Datenbank noch die Positionen der Router verändert werden, Router entfernt oder neu hinzugefügt werden. Damit die Funktionalität des Ortungssystems auch in diesen Fällen noch sichergestellt werden kann, wird z.B. in der Schrift US 7,474,897 die Qualität der Ortungsinformation jedes Routers beurteilt und damit entschieden, ob er zur Ortung genutzt werden kann.

Die Schrift US 7,493,127 beschreibt eine Methode zum Aktualisieren der Datenbank im Betrieb in dem bei jedem Ortungsvorgang die Konsistenz des Empfangsinformationen geprüft wird und im Falle inkonsistenter oder neuer Empfangsinformationen Routerpositionen auf Basis der durch andere Router bestimmten Position des Endgerätes verändert oder neu hinzugefügt werden können. Diese Methoden gewährleisten, dass die Funktionalität des Systems nicht durch die Veränderung der Eigenschaften einzelner Router eingeschränkt wird, falls eine ausreichende Anzahl anderer Router vorhanden ist, mit deren Hilfe die Position bestimmt werden kann.

Eine Möglichkeit zur Verbesserung der Ortungsgenauigkeit von Fußgängern ist die Koppelnavigation durch Ermittlung von Richtung und Wegstrecke von einem Ausgangspunkt, auch bekannt als Inertiales Navigationssystem (INS). Ein INS kann beispielsweise auf Basis von MEMS Sensoren aufgebaut sein. Hierbei wird ein Beschleunigungssensor verwendet um über das Zählen von Schritten in Kombination mit der Bestimmung der Schrittlänge eine Positionsänderung zu erfassen. Zusätzlich wird ein elektronischer Kompass, häufig in Kombination mit einem Drehratensensor, eingesetzt um die Richtung der horizontalen Fortbewegung zu bestimmen, während ein Drucksensor Bewegungen in der vertikalen Achse erkennt. Eine verbesserte Ortungsgenauigkeit durch Sensordatenfusion der INS- und WLAN-Daten wird unter anderem in "Advanced Integration of WiFi and Inertial Navigation Systems for Indoor Mobile Positioning" (Evennou, F., Marx, F., Eurasip journal on applied signal processing, Hindawi publishing corp., New York (2006)) und "WLAN-Based Pedestrian Tracking Using Particle Filters and Low-Cost MEMS Sensors" (H. Wang, H. Lenz, A. Szabo, J. Bamberger, und U. Hanebeck, Procedings of Workshop on Positioning, Navigation and Communication, 2007., pp. 1-7, 2007) erreicht. Hierbei werden die INS-Daten verwendet um die per WLAN bestimmte Position im zeitlichen Verlauf z.B. mit Hilfe eines Partikel-Filters genauer zu bestimmen, als dies ohne INS möglich gewesen wäre.

Zudem kann ein INS eingesetzt werden um die Erstellung einer "Location Fingerprinting" Datenbank zu vereinfachen, wie in "Sensor Data Fusion for Pedestrian Navigation Using WLAN and INS" (J. Seitz, L. Patiño-Studencka, B. Schindler, S. Haimerl, J. G. Boronat, S. Meyer, und J. Thielecke, in Proceedings of Gyro Technology Symposium 2007, Sep. 2007) beschrieben wird. Hierzu wird der Pfad zwischen zwei manuell eingegebenen Referenzpositionen während der Erstellung der Datenbank mit Hilfe der aus dem INS gewonnenen Daten interpoliert, wodurch weniger manuelle Eingaben benötigt werden.

Wie im Stand der Technik beschrieben, ist die Genauigkeit eines Ortungssystems durch die Qualität der zugrunde gelegten Datenbank mit Referenzpositionen, die im Falle von WLAN Ortungssytemen z.B. die Routerpositionen beinhalten kann, begrenzt. Die bekannten Methoden zur Optimierung der Datenbank verwenden nur aus dem Ortungssystem selbst gewonnene Informationen um Änderungen der Positionsreferenzen zu erkennen. So muss z.B. die aktuelle Position mit Hilfe der Empfangsstärke mehrerer Router an mehreren Orten bestimmt werden um die Position eines neuen Routers bestimmen zu können. Da die Positionsmessung hierbei mit einem Messfehler behaftet ist, ist die Unsicherheit der Position des neu bestimmten Routers größer als die der als Referenz verwendeten Router. Zudem pflanzen sich systematische Fehler bei der Positionsbestimmung, wie sie z.B. durch die Empfangseigenschaften, die durch die Orientierung des Endgerätes bedingt sind, verursacht werden können, direkt auf die Position des neuen Routers fort. Hierdurch nimmt die Qualität der Positionsdatenbank über der Zeit ab, da bei jeder Änderung einer Routerposition die Unsicherheit bezüglich seiner Position größer wird.

Neue Router können zudem nur in der Nähe mehrerer anderer Router einer Position zugeordnet werden, da sonst keine Referenzposition bestimmt werden kann. Dadurch können die Methoden zur Datenbankoptimierung nur in Gebieten mit einer hohen Dichte an Routern durchgeführt werden und versagen z.B. am Stadtrand und in ländlichen Gebieten.

Die Druckschrift US 2009/085806 A1 offenbart ein Verfahren zur Bestimmung einer Position aus Funksignalen ortsfester Sender. Weiterhin wird ein Verfahren zum Verwerfen von falschen Positionsangaben ortsfester Sender offenbart, indem die Positionsangabe mit durch Satellitennavigation ermittelten Werten oder mit Werten aus Koppelnavigation verglichen wird.

Offenbarung der Erfindung

Vorteile der Erfindung

Die Erfindung betrifft ein Verfahren zur Positionsbestimmung, mit einem ersten Schritt, wobei aus Funksignalen im wesentlichen ortsfester Sender, eine erste Folge von Positionen bestimmt wird, wobei aus sonstigen Sensordaten durch Koppeln eine zweite Folge von Positionen bestimmt wird. Der Kern der Erfindung besteht darin, dass in einem zweiten Schritt (20) die erste Folge von Positionen (12) und die zweite Folge von Positionen (14) miteinander verglichen werden.

Das erfindungsgemäße Verfahren ermöglicht eine automatisierte Verbesserung der Datenbank für die Ortung ohne erneute Vermessung mit Hilfe eines Referenzsystems. Eine schrittweise Erweiterung der Positionsdatenbank am Rand des Einsatzbereiches ist möglich. Eine Kartierung der Wege in Gebäuden ist möglich. Dies alles führt als Nutzen für den Benutzer des Ortungssystems zu einer verbesserten Ortungsgenauigkeit und für den Betreiber des Ortungssystems zu geringeren Betriebskosten, da die Qualität der Datenbank ohne zusätzlichen Aufwand im Betrieb durch die Ortungsgeräte der Benutzer verbessert werden kann.

Vorteilhaft kann das erfindungsgemäße Verfahren in einem erfindungsgemäßen Computerprogrammprodukt implementiert oder auch mit einer erfindungsgemäßen Positionsbestimmungseinrichtung durchgeführt werden.

Zeichnung

Fig. 1 zeigt ein Beispiel des erfindungsgemäßen Verfahrens zur Positionsbestimmung.
Fig. 2 zeigt das erfindungsgemäße Vergleichen einer ersten Folge von Positionen und einer zweiten Folge.
Fig. 3 zeigt ein Beispiel der erfindungsgemäßen Positionsbestimmungseinrichtung.

Beschreibung der Ausführungsbeispiele

Bisherige Systeme verwenden die INS- und WLAN-Daten um auf unterster Ebene die Positionierungsgenauigkeit zu verbessern. Gegenstand dieser Erfindung ist es, die Systeme zunächst isoliert einen zurückgelegten Weg bestimmen zu lassen und anschließend durch Vergleich der bestimmten Pfade Fehler in der Positionsbestimmung des Ortungssystems basierend auf Funksendern zu erkennen. Hierbei lassen sich insbesondere systematische Fehler in der Datenbank des Ortungssystems erkennen und neue Positionsreferenzen auch in Randgebieten und Gebieten mit wenigen Referenzen neu hinzufügen. Idee der Erfindung ist die allgemeine Optimierung von Positionsdatenbanken durch Positionsbestimmungseinrichtungen der Nutzer auf der Basis von Koppelnavigation. Dafür lassen sich beispielsweise MEMS Sensoren in den Positionsbestimmungseinrichtungen nutzen. Im Folgenden wird beispielhaft eine mögliche Implementierung vorgestellt.

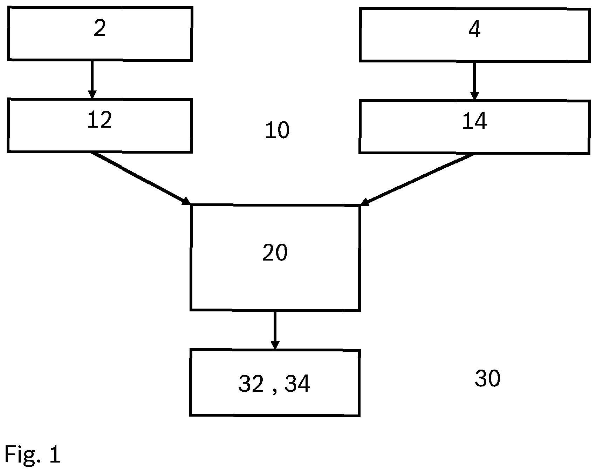

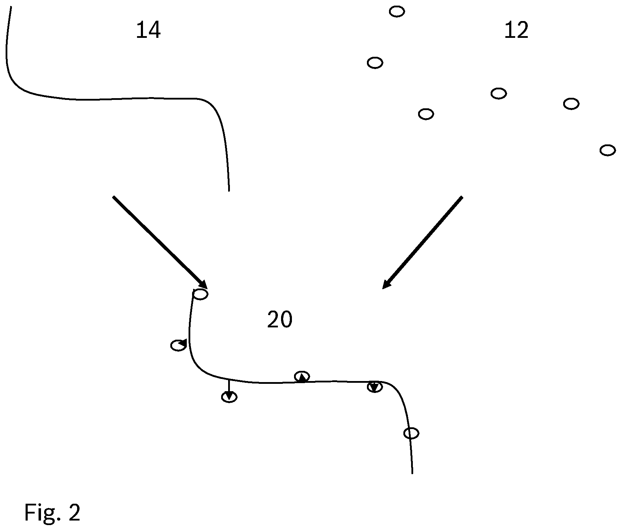

Fig. 1 zeigt ein Beispiel für das erfindungsgemäße Verfahren zur Positionsbestimmung. Am Anfang jeglicher Datenfusion steht eine Bestimmung der Genauigkeit der einzelnen Systeme. Im Falle des Ortungssystems basierend auf Funksendern wird die Bestimmung der Genauigkeit 2 üblicherweise für jede gemessene Position einzeln angegeben, für das INS kann eine die Bestimmung der Genauigkeit 4 unter anderem durch den Vergleich von Kompass- und Drehratensensor-Daten, bzw. Eigenschaften der Kompass Offset-Kompensation und Genauigkeit der Schrittlängenbestimmung ermittelt werden. Darauf folgt die Aufzeichnung der Daten während des eigentlichen Ortungsvorgangs. Beispielhaft aufgezeichnete Daten sind in Figur 2 dargestellt.

Fig. 2 zeigt das erfindungsgemäße Vergleichen einer ersten Folge von Positionen und einer zweiten Folge von Positionen. Zusätzlich zeigt dieses Beispiel einen Abgleich der beiden Folgen von Positionen um eine resultierende Folge von Positionen zu ermitteln. Aus Messungen ortsfester Funksender und mit Hilfe der Datenbank des Ortungssystems wird in einem ersten Schritt 10 eine erste Folge von Positionen 12 bestimmt. Mithilfe von Koppelnavigation in einem INS wird in demselben Schritt 10 eine zweite Folge von Positionen 14, also ein Pfad, bestimmt. In einem zweiten Schritt 20 werden die beiden Folgen von Positionen 12 und 14 miteinander verglichen. Zusätzlich werden in diesem Beispiel die beiden Folgen von Positionen 12 und 14 miteinander abgeglichen und daraus eine resultierende Folge von Positionen ermittelt. Der Vergleich bzw. die Datenfusion erfolgt z.B. mit Hilfe der Methode der kleinsten Fehlerquadrate (engl.: Least-Square-Estimation, LSE). Hierbei ist zu beachten, dass nur die translatorischen Freiheitsgrade betrachtet werden müssen, wenn als ein Sensor des INS ein Kompass verwendet wird. Eine Rotation ist in diesem Fall wegen der Messung von Absolutwerten mittels des Kompasses des INS nicht notwendig. Unter der zumeist korrekten Annahme, dass der durch das INS bestimmte Pfad genauer ist als die durch das Ortungssystem basierend auf Funksendern bestimmten Positionen, lassen sich im Anschluss an das Vergleichen so die ebenfalls in Fig. 2 als Pfeile eingezeichneten Fehler des Ortungssystems bestimmen. Durch Differentiation der bestimmten Position des Ortungssystems nach der Position der einzelnen Router lässt sich der Fehler des Positionierungssystems in einen Fehler der Datenbank umrechnen, der gewichtet mit der Genauigkeit der INS korrigiert werden kann. Der große Vorteil dieser Methode liegt darin, dass Fehler des Ortungssystems und Fehler der INS als unkorreliert angenommen werden können, wodurch eine Optimierung der Datenbank auch dann noch möglich ist, wenn keine oder nur fehlerhafte Informationen zur Positionsbestimmung mit Hilfe des Ortungssystems verwendet werden können. Dies ermöglicht die Erweiterung der Datenbank am Rande des Bereiches, für den Positionsreferenzen vorliegen. Ein weiterer großer Vorteil dieser Methode ist, dass angenommen werden kann, dass verschiedene Personen mit verschiedenen Endgeräten (d.h. Positionsbestimmungsvorrichtungen) den Ortungsvorgang vornehmen werden. Da die Fehler der INS der verschiedenen Endgeräte unkorreliert sind, heben sich diese Fehler bei mehreren Durchgänge mit verschiedene Endgeräten gegenseitig auf. Faktisch kann die Datenbank mit dieser Methode folglich besser werden, da eine im Mittel fehlerfreie Relation zwischen allen zur Positionsbestimmung verwendeten Referenzobjekten hergestellt wird. Der einzige mit dieser Methode nicht korrigierbare Fehler ist eine nicht mittelwertfreie Verschiebung der Positionen aller Referenzobjekte des Positionierungssystems. Dieser Fall besitzt jedoch praktisch keinerlei Relevanz.

Somit ergeben sich eine Reihe von Vorteilen gegenüber dem Stand der Technik. Das erfindungsgemäße Verfahren ermöglicht eine automatisierte Verbesserung der Datenbank für die Ortung (Positionsdatenbank) ohne erneute Vermessung mit Hilfe eines Referenzsystems. Eine schrittweise Erweiterung der Positionsdatenbank am Rand des Einsatzbereiches ist möglich. Eine Kartierung der Wege in Gebäuden ist möglich. Dies alles führt als Nutzen für den Benutzer des Ortungssystems zu einer verbesserten Ortungsgenauigkeit und für den Betreiber des Ortungssystems zu geringeren Betriebskosten, da die Qualität der Datenbank ohne zusätzlichen Auffand im Betrieb durch die Ortungsgeräte der Benutzer verbessert werden kann.

Das erfindungsgemäße Verfahren zur Positionsbestimmung betrifft die wesentlichen Komponenten Ortungssystem basierend auf Funksendern, INS zur Aufzeichnung eines Bewegungspfades (Koppeln), Algorithmus zur Fusion von Absolutpositionen und Pfadinformationen, Verfahren zur Optimierung der Datenbank aus den fusionierten Daten, Diese Komponenten werden im Folgenden näher beschrieben.

Ortungssystem basierend auf Funksendern

Das Ortungssystem muss auf einer Datenbank basieren, die zur Abbildung der am Endgerät ermittelten Informationen auf die aktuelle Position verwendet wird. Dies trifft insbesondere auf Ortungssysteme auf Basis von Funknetzen zu, die aktuell zumeist WLAN Netze sind. Prinzipiell können die Systeme jedoch auch auf Bluetooth oder jeder anderen Art von Funknetz basieren. Prinzipiell sind sogar nicht elektromagnetische Übertragungswege (z.B. akustisch) denkbar. Im Bereich der WLAN Ortungsverfahren kann das Verfahren insbesondere auf Systeme angewendet werden, die auf Datenbanken mit Routerpositionen basieren oder das "Position Fingerprinting" Verfahren verwenden.

Aufzeichnung des Bewegungspfades

Die Aufzeichnung eines Bewegungspfades kann, wie beschrieben, beispielsweise auf Basis von mikromechanischen Sensoren (MEMS) durchgeführt werden. MEMS sind durch ihre geringe Größe, Robustheit und geringen Energiebedarf gut für mobile Ortungsgeräte geeignet. Bei der Aufzeichnung eines Bewegungspfades werden mindestens ein Sensor zur Bestimmung des Betrages der Positionsänderung und mindestens ein Sensor zur Bestimmung der Richtung der Positionsänderung benötigt. Dies können insbesondere Beschleunigungssensoren, Kompass und Drehratensensor sein. Prinzipiell ist die Aufzeichnung von Pfadinformationen jedoch auch auf Basis anderer Sensordaten möglich, so können z.B. Geschwindigkeit und Lenkwinkel eines Fahrzeuges verwendet werden, wobei dieses Fahrzeug insbesondere ein Auto oder Fahrrad sein kann. Denkbar ist auch die Kombination von Kompass und Raddrehzahlmessung für die Anwendung auf Fahrrädern.

Fusion von Positions- und Pfadinformationen

Sowohl Positions- als auch Pfadinformationen lassen sich mathematisch als eine Menge von Tupeln $\vec{X}_i$ darstellen, die mindestens aus zwei Koordinaten bestehen, jedoch auch eine dritte Koordinate und einen Zeitstempel enthalten können.

$$\vec{X}_i = \left( x_i, y_i, z_i, t_i \right) \qquad i = 1 \ldots N$$

Hierbei kann die Anzahl an Tupeln der Positions- und Pfadinformationen verschieden sein. Es wird angenommen, dass N Positions- und M Pfadtupel existieren. Für Positionstupel wird wie oben der Index i, für Pfadtupel der Index j verwendet. Die Fusion von Pfad- und Positionsinformationen erfolgt dann durch Extremwertbestimmung einer Abbildung

$$g(\Delta) = \sum_{i,j} f(X_i, X_j, \Delta)$$

nach der Variablen $\Delta$, welche die Verschiebung zwischen Positions- und Pfadinformationen angibt. Hierbei sind insbesondere diejenigen Fälle interessant, in denen $f(X_i, X_j, \Delta)$ nur für zu einem ähnlichen Zeitpunkten aufgenommene $X_i$ und $X_j$ einen Wert ungleich null zurückgibt. Der einfachste Fall für zweidimensionale Tupel und N = M mit Gleichzeitigkeit bei i = j ist:

$$f(X_i, X_j, \Delta) = \begin{cases} 0 & \text{für } i \neq j \\ \sqrt{(\Delta_x + x_i - x_j)^2 + (\Delta_y + y_i - y_j)^2} & \text{sonst} \end{cases}$$

Hierbei gibt $\Delta_x$ die Verschiebung zwischen den Koordinatensystemen von Pfad- und Positionsinformationen in x-Richtung an. $\Delta_y$ ist analog für die y-Richtung definiert. Wird bei dieser Definition ein Minimum von $g(\Delta)$ bestimmt, kann durch die Wahl des bestimmten $\Delta$ der geometrische Abstand zwischen den Positions- und Pfadinformationen minimiert werden.

Ebenfalls möglich ist die Realisierung in mehr Dimensionen und unter Verwendung anderer Abstandsdefinitionen. Hierbei können insbesondere die Abweichungen je nach Richtung verschieden Gewichtet werden, so dass zum Beispiel eine Abweichung in y-Richtung stärker gewichtet wird als eine Abweichung in z-Richtung, da die Positionsbestimmung in z-Richtung möglicherweise ungenauer ist. Hierbei kann auch die Zeitdifferenz zwischen den Messpunkten der beiden Messsysteme analog zu den Werten der geometrischen Richtungen behandelt werden.
Resultat des Fusionsschrittes ist eine Abweichung zwischen den beiden Messsystemen in allen Dimensionen der Tupel für jeden gemessenen Punkt. Kann ein System in guter Näherung als fehlerfrei betrachtet werden, ist der bestimmte Fehler $E_i$ der Messfehler des anderen Systems am betrachteten Punkt i.

Optimierung der Datenbank

Zur Optimierung einer Datenbank auf Basis der bestimmten Fehler $E_i$ wird zunächst für jede Position oder jede Position mit einem $E_i$ oberhalb eines Schwellwertes bestimmt, welche Änderung in der Datenbank welchen Einfluss auf die gemessene Position haben. Mathematisch entspricht dies einer Differentiation der Positionen in der Datenbank $P_i$

nach einer Veränderung der gemessenen Position. Eine Korrektur der Datenbank kann folglich auf Basis dieses Wertes ausgeführt werden:

$$P_{i,neu} = P_{i,alt} + k * \frac{\partial \bar{P}_i}{\partial X_i} * E_i$$

Hierbei ist k ein Faktor mit der die Veränderung der Datenbank gewichtet wird. Dieser Faktor hängt z.B. von der Genauigkeit der Messsysteme und der erwünschten Optimierungsgeschwindigkeit der Datenbank ab.

Gibt es für eine Position keine Einträge in der Positionsdatenbank, es konnte jedoch auf Basis vorher bestimmter Positionen und des gemessenen Pfades eine Position bestimmt werden, kann diese dazu verwendet werden um wie im Stand der Technik beschrieben die Position noch unbekannter Positionsreferenzen (häufig WLAN Router) zu ermitteln.

Zusammengefaßt beinhaltet das erfindungsgemäße Verfahren zur Positionsbestimmung die wesentlichen Merkmale eines ersten Schritts 10, bei dem aus Funksignalen im wesentlichen ortsfester Sender, eine erste Folge von Positionen 12 und aus sonstigen Sensordaten durch Koppeln eine zweite Folge von Positionen 14 bestimmt wird, sowie die erfindungsgemäßen Merkmale eines zweiten Schritts 20, bei dem die erste Folge von Positionen 12 und die zweite Folge von Positionen 14 miteinander verglichen werden.

In einer Ausgestaltung des erfindungsgemäßen Verfahrens werden die erste Folge von Positionen 12 und die zweite Folge von Positionen 14 abgeglichen und aus dem Abgleich eine resultierende Folge von Positionen ermittelt.

In einem Ausführungsbeispiel des erfindungsgemäßen Verfahrens, das die Ortungsmethode des "Position Fingerprinting" verwendet, wird die erste Folge von Positionen 12 aus gespeicherten Informationen über möglichen Standorten zugeordnete Sender, beispielsweise aus einer Positionsdatenbank, bestimmt. In einem anderen Ausführungsbeispiel des erfindungsgemäßen Verfahrens, das die Ortungsmethode des "Signal Path Modelling" verwendet, wird die erste Folge von Positionen 12 aus gespeicherten Positionen und/oder Signalstärken von Sendern, beispielsweise aus einer Positionsdatenbank, bestimmt.

In einer Ausgestaltung des erfindungsgemäßen Verfahrens wird nach dem zweiten Schritt 20 in einem dritten Schritt 30 wenigstens eine Position 32 aus der ersten Folge von Positionen 12 korrigiert. Damit kann die Positionsdatenbank verbessert werden. In einer Ausgestaltung des erfindungsgemäßen Verfahrens werden nach dem zweiten Schritt 20 in einem dritten Schritt 30 wenigstens für eine Position 34 aus der ersten Folge von Positionen 12 Informationen über zugeordnete Sender oder Position und/oder Signalstärke wenigstens eines Senders gespeichert. Damit kann die Positionsdatenbank um einen neuen Eintrag ergänzt und somit erweitert werden. Das erfindungsgemäße Verfahren kann auch mehrmals hintereinander durchgeführt werden. So kann beispielsweise nach dem zweiten Schritt 20 oder nach dem dritten Schritt 30 wieder der erste Schritt 10 durchgeführt werden. Dabei kann insbesondere im ersten Schritt 10 die erste Folge von Positionen 12 und auch die zweite Folge von Positionen 14 durch Anhängen neuer Positionen zu jeweils einer neuen von Positionen ergänzt werden, die dann im zweiten Schritt 20 dem Abgleich, bzw. der Datenfusion zugeführt werden. In einem Ausführungsbeispiel des Verfahrens wird vor dem ersten Schritt 10 die Genauigkeit 2 der einzelnen Positionsbestimmung für die Positionen der ersten Folge 12 und auch die Genauigkeit 4 für die Positionen der zweiten Folge 14 bestimmt.

Neben dem oben beschriebenen erfindungsgemäßen Verfahren zur Positionsbestimmung ist auch ein Computerprogrammprodukt zur Durchführung dieses Verfahrens Gegenstand der Erfindung.

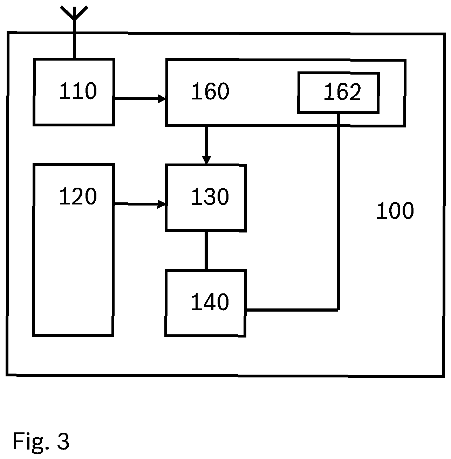

Daneben ist auch eine Positionsbestimmungseinrichtung Gegenstand der Erfindung. Fig. 3 zeigt ein Beispiel der erfindungsgemäßen Positionsbestimmungseinrichtung. Dargestellt ist eine Positionsbestimmungseinrichtung 100, die beispielsweise in einem mobilen Endgerät angeordnet sein kann. Die Positionsbestimmungseinrichtung 100 beinhaltet einen Empfänger 110 für Funksignale ortsfester Sender, Positionsbestimmungsmittel 160 zur Bestimmung einer ersten Position des Empfängers aus Funksignalen ortsfester Sender, sowie Sensoren 120 zur Bestimmung einer zweiten Position durch Koppelnavigation, d.h. durch Koppeln. Die Sensoren 120 beinhalten dazu wenigstens einen Sensor zur Ermittlung einer Richtung, wie beispielsweise einen elektronischer Kompass, einen Drehratensensor oder einen Drehbeschleunigungssensor und wenigstens einen Sensor zur Ermittlung einer Wegstrecke, wie beispielsweise einen Schrittzähler, einen Wegstreckenzähler, einen Geschwindigkeitsmesser oder einen Beschleunigungssensor. Zur Ermittlung einer vertikalen Wegstreckenkomponente kann beispielsweise auch ein Drucksensor enthalten sein. Diese Sensoren können beispielsweise als MEMS ausgestaltet sein. MEMS sind vorteilhaft kompakt in der Bauform, robust und energiesparend im Betrieb. Die Positionsbestimmungseinrichtung 100 beinhaltet weiter einen Speicher 130 zum Speichern einer Folge erster Positionen und einer Folge zweiter Positionen. Die Positionsbestimmungseinrichtung weist erfindungsgemäß eine Verarbeitungseinrichtung 140 zum Vergleich der Folge erster Positionen und der Folge zweiter Positionen auf.

Die Verarbeitungseinrichtung ist in einem Ausführungsbeispiel so konfiguriert, beispielsweise gemäß obigem Ausführungsbeispiel des erfindungsgemäßen Verfahrens im zweiten Schritt 20, den Abgleich, bzw. die Datenfusion der beiden Folgen von Positionen durchzuführen und insbesondere eine resultierende Folge von Positionen zu ermitteln.

Die Positionsbestimmungsmittel 160 umfassen in einem Ausführungsbeispiel eine Datenbank 162 zur Speicherung von Informationen über möglichen Standorten zugeordnete Sender, d.h. also eine Datenbank mit Informationen für die Ortungsmethode des "Position Fingerprinting", bei der zu einem Raster von möglichen Positionen der Positionsbestimmungseinrichtung die Empfangsstärken aller verfügbaren Funksender, beispielsweise WLAN-Netzwerke verzeichnet sind. Die Positionsbestimmungsmittel 160 umfassen in einem Ausführungsbeispiel eine Datenbank 162 zur Speicherung von Positionen und/oder Signalstärken von Sendern für die Ortungsmethode des "Signal Path Modelling".

**Patentansprüche**

1. Verfahren zur Optimierung der Positionsdatenbank eines Ortungssystems, in der Positionsreferenzen von im Wesentlichen ortsfesten Sendern abgespeichert sind, wobei diese Positionsreferenzen zur Positionsbestimmung genutzt werden
   bei dem in einem ersten Schritt

   • aus den Funksignalen der im wesentlichen ortsfesten Sender unter Zuhilfenahme der Positionsdatenbank mit Hilfe einer Positionsbestimmungseinrichtung eine erste Folge von Positionen (12) eines zurückgelegten Weges bestimmt wird, und
   • aus sonstigen Sensordaten eines Inertialen Navigationssystems, INS, der Positionsbestimmungseinrichtung durch Koppeln eine zweite Folge von Positionen (14) des zurückgelegten Weges bestimmt wird,

   bei dem in einem zweiten Schritt (20)

   • die erste Folge von Positionen (12) und die zweite Folge von Positionen (14) miteinander verglichen werden,

   bei dem, unter der Annahme, dass der durch das INS aus der zweiten Folge von Positionen (14) bestimmte Pfad genauer ist, als die durch das Ortungssystem bestimmte erste Folge von Positionen (12), Fehler des Ortungssystems ermittelt werden, und zwar Fehler $E_i$ für die Positionen (12) der ersten Folge,
   bei dem für jede Position (12) der ersten Folge bestimmt wird, welchen Einfluss eine Änderung der Positionsdatenbank auf die Bestimmung dieser Position (12) hat, und
   bei dem auf Basis dieser Informationen und der ermittelten Fehler $E_i$ eine Korrektur der Positionsdatenbank vorgenommen wird.

2. Verfahren nach Anspruch 1, **dadurch gekennzeichnet, dass** in dem zweiten Schritt (20) die erste Folge von Positionen (12) und die zweite Folge von Positionen (14) abgeglichen werden und aus dem Abgleich eine resultierende Folge von Positionen ermittelt wird.

3. Verfahren nach Anspruch 1, **dadurch gekennzeichnet, dass** die erste Folge von Positionen (12) aus gespeicherten Positionen und Signalstärken von Sendern bestimmt wird.

4. Verfahren nach einem der vorhergehenden Ansprüche 1 bis 3, **dadurch gekennzeichnet, dass** in einem dritten Schritt (30) wenigstens eine Position (32) aus der ersten Folge von Positionen (12) korrigiert wird.

5. Verfahren nach einem der vorhergehenden Ansprüche 1 bis 3, **dadurch gekennzeichnet, dass** in einem dritten Schritt (30) wenigstens für eine Position aus der ersten Folge von Positionen (12) Informationen über zugeordnete Sender oder Position und/oder Signalstärke wenigstens eines Senders (34) gespeichert werden.

6. Verfahren nach einem der vorhergehenden Ansprüche, **dadurch gekennzeichnet, dass** das Verfahren mehrmals nacheinander durchgeführt wird.

7. Verfahren nach einem der vorhergehenden Ansprüche, **dadurch gekennzeichnet, dass** auf Basis von vorher bestimmten Positionen und des gemessenen Pfades eine neue Position bestimmt wird, für die keine Einträge in der Positionsdatenbank vorliegen, und dass diese neue Position dazu verwendet wird, um neue Positionsreferenzen zu ermitteln und zur Positionsdatenbank hinzuzufügen.

8. Verfahren nach einem der vorhergehenden Ansprüche, **dadurch gekennzeichnet, dass** vor dem ersten Schritt (10) die Genauigkeit (2) der einzelnen Positionsbestimmung für die Positionen der ersten Folge (12) und/oder die Genauigkeit (4) für die Positionen der zweiten Folge (14) bestimmt wird.

9. Computerprogrammprodukt, umfassend Befehle, die bewirken, dass eine Positionsbestimmungseinrichtung gemäß den nachfolgenden Ansprüchen ein Verfahren gemäß einem der vorhergehenden Ansprüche ausführt.

10. Positionsbestimmungseinrichtung (100), insbesondere in einem mobilen Endgerät,

- mit einem Empfänger (110) für Funksignale ortsfester Sender,
- mit Positionsbestimmungsmitteln (160) zur Bestimmung einer ersten Position des Empfängers aus Funksignalen ortsfester Sender,
- mit Sensoren (120) wenigstens zur Ermittlung einer Richtung und einer Wegstrecke zur Bestimmung einer zweiten Position durch Koppeln,
- mit einem Speicher (130) zum Speichern einer Folge erster Positionen und einer Folge zweiter Positionen, **dadurch gekennzeichnet,**
**dass** die Positionsbestimmungseinrichtung (100) ein Inertiales Navigationssystem für das Koppeln zur Bestimmung der zweiten Position aufweist,
**dass** die Positionsbestimmungsmittel (160) eine Datenbank (162) mit Positionsreferenzen von im Wesentlichen ortsfesten Sendern umfassen, dass die Positionsbestimmungseinrichtung eine Verarbeitungseinrichtung (140) zum Vergleich der Folge erster Positionen und der Folge zweiter Positionen aufweist und zum Optimieren der Datenbank gemäß einem Verfahren nach einem der Ansprüche 1 bis 8 ausgebildet ist.

11. Positionsbestimmungseinrichtung nach Anspruch 10, **dadurch gekennzeichnet, dass** Verarbeitungseinrichtung (140) zum Abgleich der Folge erster Positionen und der Folge zweiter Positionen konfiguriert ist, um eine resultierende Folge von Positionen zu ermitteln.

12. Positionsbestimmungseinrichtung nach Anspruch 10 oder 11, **dadurch gekennzeichnet, dass** die Positionsbestimmungsmittel (160) eine Datenbank (162) zur Speicherung von Positionen und Signalstärken von Sendern umfassen.

13. Positionsbestimmungseinrichtung nach einem der Ansprüche 10 bis 12, **dadurch gekennzeichnet, dass** die Positionsbestimmungseinrichtung einen Drehratensensor und/oder einen elektronischen Kompass und/oder einen Beschleunigungssensor und/oder einen Schrittzähler und/oder einen Drucksensor aufweist.

**Claims**

1. Method for optimizing the position database of a location system, in which position database position references of substantially stationary transmitters are stored, wherein said position references are used for position determination, in which in a first step

• a first sequence of positions (12) of a covered distance is determined from the radio signals of the substantially stationary transmitters with the assistance of the position database with the aid of a position determination device, and
• a second sequence of positions (14) of the covered distance is determined from other sensor data of an inertial navigation system, INS, of the position determination device by way of coupling,

in which in a second step (20)

• the first sequence of positions (12) and the second sequence of positions (14) are compared with one another,

in which, assuming that the distance determined by the INS from the second sequence of positions (14) is more accurate than the first sequence of positions (12) determined by the location system, errors in the location system are identified, and specifically errors $E_i$ for the positions (12) of the first sequence,
in which, for each position (12) of the first sequence, the influence that a change in the position database has on the determination of said position (12) is determined, and
in which a correction to the position database is performed on the basis of said information and the identified errors $E_i$.

2. Method according to Claim 1, **characterized in that**, in the second step (20), the first sequence of positions (12) and the second sequence of positions (14) are adjusted and a resulting sequence of positions is identified from the adjustment.

3. Method according to Claim 1, **characterized in that** the first sequence of positions (12) is determined from stored positions and signal strengths of transmitters.

4. Method according to one of the preceding Claims 1 to 3, **characterized in that**, in a third step (30), at least one position (32) from the first sequence of positions (12) is corrected.

5. Method according to one of the preceding Claims 1 to 3, **characterized in that**, in a third step (30), information about associated transmitters or positions and/or signal strength of at least one transmitter (34) is stored at least for a position from the first sequence of positions (12).

6. Method according to one of the preceding claims, **characterized in that** the method is carried out multiple times consecutively.

7. Method according to one of the preceding claims, **characterized in that**, based on previously determined positions and the measured distance, a new position is determined for which there are no entries in the position database, and **in that** said new position is used to identify new position references and to add to the position database.

8. Method according to one of the preceding claims, **characterized in that**, before the first step (10), the accuracy (2) of the individual position determination for the positions of the first sequence (12) and/or the accuracy (4) for the positions of the second sequence (14) is determined.

9. Computer program product, comprising commands that cause a position determination device according to the following claims to execute a method according to one of the preceding claims.

10. Position determination device (100), in particular in a mobile terminal,

   - having a receiver (110) for radio signals of stationary transmitters,
   - having position determination means (160) for determining a first position of the receiver from radio signals of stationary transmitters,
   - having sensors (120) at least for identifying a direction and a route for determining a second position by way of coupling,
   - having a memory (130) for storing a sequence of first positions and a sequence of second positions, **characterized in that**
   the position determination device (100) has an inertial navigation system for coupling to determine the second position,
   the position determination means (160) comprise a database (162) having position references of substantially stationary transmitters,
   the position determination device has a processing device (140) for comparing the sequence of first positions and the sequence of second positions and is designed for optimizing the database in accordance with a method according to one of Claims 1 to 8.

11. Position determination device according to Claim 10, **characterized in that** the processing device (140) is configured to adjust the sequence of first positions and the sequence of second positions in order to identify a resulting sequence of positions.

12. Position determination device according to Claim 10 or 11, **characterized in that** the position determination means (160) comprise a database (162) for storing positions and signal strengths of transmitters.

13. Position determination device according to one of Claims 10 to 12, **characterized in that** the position determination device has a rate of rotation sensor and/or an electronic compass and/or an acceleration sensor and/or a step counter and/or a pressure sensor.

**Revendications**

1. Procédé d'optimisation de la base de données de position d'un système de positionnement, dans lequel des références de position d'émetteurs sensiblement fixes sont mémorisées, dans lequel lesdites références de position sont utilisées pour la détermination de position,

dans lequel, lors d'une première étape

- une première série (12) de positions d'un trajet parcouru est déterminée à partir des signaux radio d'émetteurs sensiblement fixes par utilisation de la base de données de positions et à l'aide d'un système de détermination de position, et
- une deuxième séquence (14) de positions du trajet parcouru est déterminée par couplage à partir d'autres données de capteurs d'un système de navigation inertiel, INS, du système de détermination de position, dans lequel, lors d'une deuxième étape (20),
- la première série (12) de positions et la deuxième série (14) de positions sont comparées l'une à l'autre, dans lequel, en supposant que le trajet déterminé par l'INS à partir de la deuxième série (14) de positions est plus précis que la première série (12) de positions déterminée par le système de positionnement, des erreurs du système de positionnement sont déterminées, à savoir des erreurs $Ei$ pour les positions (12) de la première série, dans lequel, pour chaque position (12) de la première série, l'influence d'une modification de la base de données de positions sur la détermination de ladite position (12) est déterminée, et

dans lequel, sur la base desdites informations et des erreurs $E_i$ déterminées, une correction est apportée à la base de données de positions.

2. Procédé selon la revendication 1, **caractérisé en ce que**, lors de la deuxième étape (20), la première série (12) de positions et la deuxième série (14) de positions sont ajustées l'une par rapport à l'autre et une série de positions résultante est déterminée à partir de l'ajustement.

3. Procédé selon la revendication 1, **caractérisé en ce que** la première série (12) de positions est déterminée à partir de positions et d'intensités de signaux mémorisées d'émetteurs.

4. Procédé selon l'une des revendications 1 à 3 précédentes, **caractérisé en ce que**, lors d'une troisième étape (30), au moins une position (32) provenant de la première série (12) de positions est corrigée.

5. Procédé selon l'une des revendications 1 à 3 précédentes, **caractérisé en ce que**, lors d'une troisième étape (30), au moins pour une position provenant de la première série (12) de positions, des informations concernant des émetteurs associés ou la position et/ou l'intensité de signal d'au moins un émetteur (34) sont mémorisées.

6. Procédé selon l'une des revendications précédentes, **caractérisé en ce que** le procédé est exécuté plusieurs fois de suite.

7. Procédé selon l'une des revendications précédentes, **caractérisé en ce que**, sur la base de positions déterminées précédemment et du trajet mesuré, une nouvelle position pour laquelle il n'existe aucune entrée dans la base de données de positions est déterminée, et **en ce que** ladite nouvelle position est utilisée pour déterminer de nouvelles références de position et pour les ajouter à la base de données de positions.

8. Procédé selon l'une des revendications précédentes, **caractérisé en ce qu'**avant la première étape (10), la précision (2) de la détermination de position individuelle pour les positions de la première série (12) et/ou la précision (4) pour les positions de la deuxième série (14) est déterminée.

9. Produit de programme informatique comprenant des instructions qui amènent un système de détermination de position selon les revendications suivantes à exécuter un procédé selon l'une des revendications précédentes.

10. Système de détermination de position (100), en particulier dans un terminal mobile, comportant

- un récepteur (110) pour des signaux radio d'émetteurs fixes,
- des moyens de détermination de position (160) pour la détermination d'une première position du récepteur à partir de signaux radio d'émetteurs fixes,
- des capteurs (120) au moins pour la détermination d'une direction et d'un trajet pour la détermination d'une deuxième position par couplage,
- une mémoire (130) servant à mémoriser une série de premières positions et une série de deuxièmes positions, **caractérisé**

**en ce que** le système de détermination de position (100) comprend un système de navigation inertiel servant au couplage pour la détermination de la deuxième position, en ce que les moyens de détermination de position (160) comprennent une base de données (162) avec des références de position d'émetteurs sensiblement fixes, **en ce que** le système de détermination de position comporte un système de traitement (140) destiné à la comparaison de la série de premières positions et de la série de deuxièmes positions et est conçu pour optimiser la base de données conformément à un procédé selon l'une des revendications 1 à 8.

11. Système de détermination de position selon la revendication 10, **caractérisé en ce que** le système de traitement (140) destiné à l'ajustement l'une par rapport à l'autre de la série de premières positions et de la série de deuxièmes positions est configuré pour déterminer une série résultante de positions.

12. Système de détermination de position selon la revendication 10 ou 11, **caractérisé en ce que** les moyens de détermination de position (160) comprennent une base de données (162) servant à mémoriser des positions et des intensités de signaux d'émetteurs.

13. Système de détermination de position selon l'une des revendications 10 à 12, **caractérisé en ce que** le système de détermination de position comprend un capteur de vitesse de rotation et/ou une boussole électronique et/ou un capteur d'accélération et/ou un podomètre et/ou un capteur de pression.

Fig. 1

14　　　　　　　　　　　　　　12

20

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7403762 B
- US 7474897 B
- US 7493127 B
- US 2009085806 A1

**In der Beschreibung aufgeführte Nicht-Patentliteratur**

- Advanced Integration of WiFi and Inertial Navigation Systems for Indoor Mobile Positioning. **EVENNOU, F. ; MARX, F.** Eurasip journal on applied signal processing. Hindawi publishing corp, 2006
- **H. WANG ; H. LENZ ; A. SZABO ; J. BAMBERGER ; U. HANEBECK.** WLAN-Based Pedestrian Tracking Using Particle Filters and Low-Cost MEMS Sensors. *Procedings of Workshop on Positioning, Navigation and Communication,* 2007, 1-7
- **J. SEITZ ; L. PATIÑO-STUDENCKA ; B. SCHINDLER ; S. HAIMERL ; J. G. BORONAT ; S. MEYER ; J. THIELECKE.** Sensor Data Fusion for Pedestrian Navigation Using WLAN and INS. *Proceedings of Gyro Technology Symposium 2007,* September 2007